# EUROPEAN PATENT SPECIFICATION

(11) **EP 3 262 695 B1**
(45) Date of publication and mention of the grant of the patent: **22.04.2020**
(21) Application number: 16704463.5
(22) Date of filing: 16.02.2016
(51) Int. Cl.: H01L 33/50, H01L 33/44

(54) **LIGHT SOURCE ASSEMBLY WITH IMPROVED COLOR UNIFORMITY**
LICHTQUELLENANORDNUNG MIT VERBESSERTER FARBGLEICHMÄSSIGKEIT
ENSEMBLE DE SOURCE DE LUMIÈRE AYANT UNE UNIFORMITÉ DE COULEUR AMÉLIORÉE

(30) Priority: 23.02.2015 EP 15156052
(43) Date of publication of application: 03.01.2018
(73) Proprietor: Lumileds Holding B.V., 1118 CL Schiphol (NL)
(72) Inventor: STELTENPOL, Mark, Aachen 52068 (DE); CORNELISSEN, Hugo Johan, 52068 Aachen (DE); LIBON, Sébastien Paul René, 52068 Aachen (DE); BLOEMEN, Pascal Jean Henri, 52068 Aachen (DE); NIJKAMP, Rick Gerhardus, 52068 Aachen (DE); VAN LIEROP, Maarten, 52068 Aachen (DE)
(74) Representative: ter Heegde, Paul Gerard Michel
(86) International application number: PCT/EP2016/053237
(87) International publication number: WO 2016/135006

(56) References cited:
- WO-A1-2012/140542
- US-A1- 2010 051 984
- US-A1- 2011 001 151
- US-A1- 2013 221 389

## Description

### TECHNICAL FIELD

The invention relates to a light source assembly having a solid state lighting (SSL) device and a wavelength converting element arranged to receive light emitted by the SSL device and adapted to convert some of the received light to a different wavelength. The invention also relates to a method for producing such a light source assembly.

### BACKGROUND

A common technique to provide white light is to combine a non-white light source with a wavelength converter, a case in point being that of a blue light emitting diode (LED) having a layer of phosphor with an emission spectrum in the wavelength range of yellow light. Some of the blue light from the light emitting diode is absorbed by the phosphor which then emits yellow light that mixes with the remaining blue light to form white light. The light emitted by these types of lighting devices is usually not completely uniformly white but varies slightly in color, and various techniques for color correction are known in the art. US 2009/0236967 A1, for example, teaches that the chromaticity of the light from an LED with a phosphor layer can be adjusted by means of an ink layer applied on top of the phosphor layer. Despite the efforts that have gone into developing these techniques, there is still a need for further work in this area. US 2011/001151 (A1) discloses an LED package comprising at least one LED that emits LED light in an LED emission profile. The LED package includes regions of scattering particles with the different regions scattering light primarily at a target wavelength or primarily within a target wavelength range. The location of the regions and scattering properties are based at least partially on the LED emission profile. The regions scatter their target wavelength of LED light to improve the uniformity of the LED emission profile so that the LED package emits a more uniform profile compared to the LED emission profile. WO 2012/140542 A1 discloses a luminescent converter. US 2010/0051984 A1 discloses a die emitting light through a top surface of a light conversion layer and comprising a scattering ring surrounding the side surfaces of the die and redirecting light received from the die to the light conversion layer.

### SUMMARY

It would be advantageous to provide a light source assembly with improved color uniformity, in particular such light source assemblies intended to generate white light.

To address this concern, there is, according to a first aspect, presented a light source assembly which comprises: an solid state lighting device; a wavelength converting element arranged to receive light emitted by the solid state lighting device, adapted to convert some of the received light to a different wavelength and comprising a light emitting surface; and a scattering layer applied to a light emitting surface of the wavelength converting element. The scattering layer is adapted to scatter light back through the light emitting surface into the wavelength converting element, and a backscattering strength of the scattering layer varies over said light emitting surface so as to reduce variations in the color of the light emitted from the light emitting surface. The back scattering strength varies in the range of 10% to 50% of the light emitted from the light emitting surface.

By "backscattering strength" is here meant the degree with which the scattering layer scatters the light emitted from the light emitting surface back to the wavelength converting element.

The SSL device may for example be a semiconductor LED, an organic LED, a polymer LED or a laser diode.

The backscattering provided by the scattering layer is such that the variations in color of the light emitted from the light emitting surface are reduced. The reduced variations make the light appear more uniform to an observer in the far field.

The color uniformity in the near field and in the far field may be improved by the scattering layer described above as compared with light source assemblies without such a layer. The scattering layer may be adapted to correct for various types of color variations, such as color over position (i.e. the color of the emitted light depends on the position of emission), color over angle (i.e. the color of the emitted light depends on the emission angle) and color temperature variations between the LEDs of different LED packages. The scattering layer can be applied by means of an additive manufacturing process to standard "off the shelf' LED packages, for example mid power white LED packages, thereby making them more suitable for high end lighting applications requiring uniformly colored light. The applying of the scattering layer can easily be integrated with an already existing LED package manufacturing process or be a completely separate step, possibly performed at a different manufacturing facility. The scattering layer enables a high degree of customization of the final product and may reduce the need for LED "binning". Moreover, by scattering light back into the wavelength converting element, the scattering layer increases path length of the light through the wavelength converting element and, as a result, the amount of light that is wavelength converted. Hence, a thinner wavelength converting element may be used without reducing the overall conversion performance, whereby material costs may be reduced.

According to one embodiment, the scattering layer has a varying density, the backscattering strength being determined by said density. Such scattering layers may be produced by standard techniques and may be used to reduce many different kinds of color variations.

According to one embodiment, the scattering layer has a varying thickness perpendicular to the light emitting surface, the backscattering strength being determined by said thickness. Such scattering layers may be used to reduce many different kinds of color variations and may be produced by various techniques, such as 3D printing, inkjet printing and laser ablation, for example CO2 laser ablation. By these techniques, it is possible to create a scattering layer that has a fine tuned varying thickness.

According to one embodiment, the scattering layer comprises scattering elements chosen from the group consisting of gas bubbles, titanium oxide particles, phosphor particles, metallic flakes, polymer beads and glass beads.

According to one embodiment, the scattering layer comprises wavelength converting particles. Including wavelength converting particles in the scattering layer may increase the efficiency with which color variations are reduced and strengthen the color correcting capability of the scattering layer. A thinner scattering layer may be then used, whereby the amount of material necessary to produce the layer is reduced. Moreover, the wavelength converting particles creates an additional degree of freedom, facilitating cost and performance optimization.

According to one embodiment, the wavelength converting layer and the scattering layer comprise the same type of wavelength converting particles. This may be preferred from a production standpoint since the production process can be streamlined.

According to one embodiment, the wavelength converting particles are phosphor particles. Phosphor is an efficient wavelength converter and therefore particularly suitable for the present invention.

According to one embodiment, the color of the light leaving the light emitting surface depends on the position from which the light leaves the light emitting surface. Such a color dependence of the emitted light's position of emission is usually referred to as color over position variation. This is a problem typically associated with mid power light emitting diodes.

According to one embodiment, the light emitting surface is flat. This is usually the case for "off the shelf' LED packages, and such layers may be particularly robust.

According to a second aspect, there is presented a method for manufacturing a light source assembly. The method comprises: providing a solid state lighting device and a wavelength converting element, wherein the wavelength converting element is arranged to receive light emitted by the solid state lighting device and adapted to convert some of the received light to a different wavelength; measuring variations in the color of the light emitted from a light emitting surface of the wavelength converting element; and applying a scattering layer to the light emitting surface. The scattering layer is adapted to scatter light back through the light emitting surface into the wavelength converting element, and a backscattering strength of the scattering layer is selected to vary over said light emitting surface so as to reduce the measured variations in the color of the light emitted from the light emitting surface. The back scattering strength varies in the range of 10% to 50% of the light emitted from the light emitting surface.

The technical effects and features of the second aspect are largely analogous to those of the first aspect.

According to one embodiment of the method, the scattering layer is applied by additive manufacturing techniques such as three dimensional (3D) printing. This makes it possible to create a scattering layer having a complicated 3D structure.

According to one embodiment of the method, the scattering layer is applied to the light emitting surface in the form of a droplet. Such a scattering layer can be applied using inkjet printing, a simple and relatively cheap printing method.

It is noted that the invention relates to all possible combinations of features recited in the claims.

### BRIEF DESCRIPTION OF THE DRAWINGS

This and other aspects of the present invention will now be described in more detail, with reference to the appended drawings showing embodiment(s) of the invention.
- Figure 1: shows a schematic perspective view of an embodiment of a light source assembly having a flat scattering layer.
- Figure 2: shows a schematic cross sectional view of the light source assembly in figure 1.
- Figure 3: shows a schematic cross sectional view of an embodiment of a light source assembly having a scattering layer with varying thickness.
- Figure 4: shows a schematic cross sectional view of an embodiment of a light source assembly having a scattering layer in the form of a droplet.
- Figure 5: is a flowchart of some of the steps of a method for manufacturing a light source assembly.

As illustrated in the figures, the sizes of layers and regions are exaggerated for illustrative purposes and, thus, are provided to illustrate the general structures of embodiments of the present invention. Like reference numerals refer to like elements throughout.

### DETAILED DESCRIPTION

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled person.

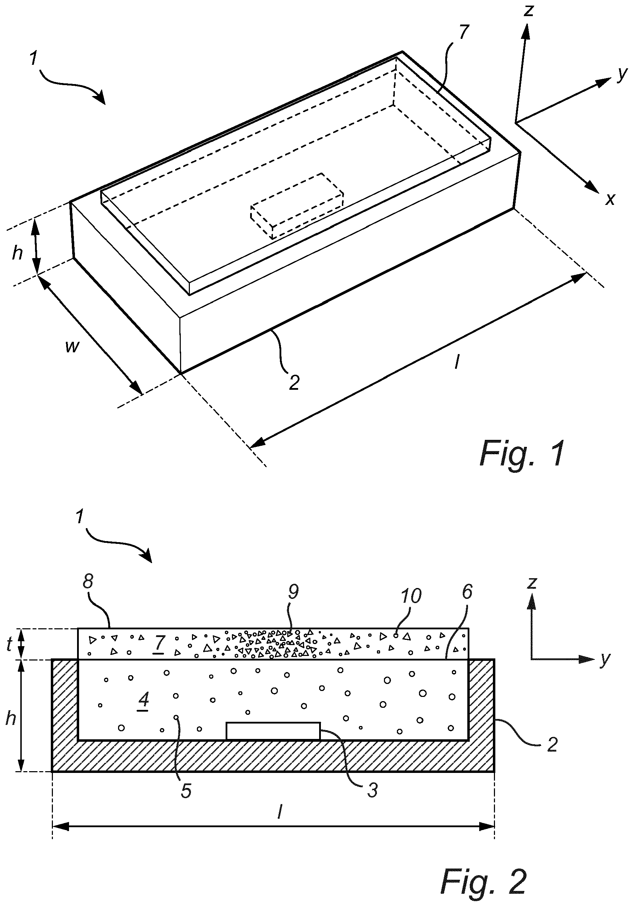

Figures 1 and 2 illustrate a light source assembly 1 that may be used in for example luminaires and retrofit lamps. The light source assembly 1 includes a substrate 2 having the shape of an open rectangular box. The substrate 2 may have a different shape in other embodiments. The substrate 2 may for example have the shape of a plate. The height h of the substrate may for example be in the range from about 300 µm to about 400 µm, the width w of the substrate may for example be in the range from about 1 mm to about 6 mm, and the length 1 of the substrate may for example be in the range from about 2 mm to about 6 mm. The substrate 2 can for example be made of an injection molded white reflective polymer. An SSL (solid state lighting) device 3 in the form of an LED is mounted on the substrate 2, more precisely in a recessed portion defined of the substrate 2. The substrate 2 and the SSL device 3 are electrically and thermally connected. The electrical connections between the SSL device 3 and the substrate 2 may for example be wires. The SSL device 3 is arranged so as to emit light away from the substrate 2. The SSL device 3 is configured to emit monochromatic light, for example blue light or near ultraviolet radiation.

A wavelength converting element 4 is arranged to receive light emitted by the SSL device 3 and adapted to convert some of the received light to a different wavelength. In this embodiment, the SSL device 3 is partly embedded in the wavelength converting element 4. The wavelength (i.e. the color) of the converted light is such that, when the right proportions of the converted light and the light from the SSL device 3 are mixed, the result is light that appears white to an observer. For example, if the light emitted by the SSL device 3 is blue, then the wavelength converting element 4 is adapted to convert blue light to green or red light. The wavelength converting element 4 comprises wavelength converting particles 5 which are capable of wavelength converting the light emitted by the SSL device 3. In this embodiment, the wavelength converting element 4 comprises phosphor particles, for example an organic phosphor particles or an inorganic phosphor. There are many commercially available phosphors that may be used. In other embodiments, the wavelength converting element 4 may comprise a luminescent material other than phosphor, such as a luminescent dye. According to some embodiments, the wavelength converting element 4 includes quantum dots capable of wavelength converting the light emitted by the SSL device 3, quantum dots being nano-sized semiconductor crystal which, when excited by incident light, emits light of a colour determined by the size and the material of the crystal.

The wavelength converting element 4 has a light emitting surface 6 through which light emitted by the SSL device 3 and wavelength converted light may leave the wavelength converting element 4. The light emitting surface 6 and the SSL device 3 are arranged at opposite sides of the wavelength converting element 4. The light emitting surface 6 is rectangular and flat, extending in a plane defined by the x- and y-axis of a Cartesian coordinate system having axes x, y and z. The surface normal of the light emitting surface 6 is parallel with the z-axis. The color of the light leaving the light emitting surface 6 depends on the position from which the light leaves the light emitting surface 6 due to color over position variation. The substrate 2, SSL device 3 and the wavelength converting element 4 together form an LED package, for example an LED package of the type that is commercially available under the name "Nichia NSSL 157".

A scattering layer 7 is applied to the light emitting surface 6. The scattering layer 7 may be in direct contact with the light emitting surface 6 or in indirect contact with the light emitting surface 6. There may be a layer, for example an adhesive layer, arranged between the scattering layer 7 and the light emitting surface 6 for improved attachment of the scattering layer 7 to the light emitting surface 6. The scattering layer 7 covers substantially the entire light emitting surface 6. A light exit surface 8 of the scattering layer 7 faces away from the light emitting surface 6. The scattering layer 7 is flat, having a substantially uniform thickness t in the z direction and extending in a plane parallel with the x-y plane. The thickness t may for example be in the range from around 50 µm to around 200 µm. The scattering layer 7 is adapted to scatter light back to the wavelength converting element 4 through the light emitting surface 6. The backscattering strength of the scattering layer 7 varies over the light emitting surface 6, that is to say, the backscattering strength varies in the x and y directions. Hence, the backscattering strength at different x-y coordinates may or may not be the same. The backscattering strength varies in such a way that the variations in the color of the light emitted from the light emitting surface 6 are reduced. In this embodiment, the density of the scattering layer 7 varies over the light emitting surface 6 (i.e. in the x and y directions), and the density is highest above the SSL device 3 as viewed in the z direction. The backscattering strength is determined by the density of the scattering layer 7, the backscattering strength being stronger where the density of scattering layer 7 is higher. The backscattering strength varies between values that lie in the range from about 10% to about 50%, a backscattering strength of X% meaning that X% of the light that is received by the scattering layer 7 is backscattered.

The backscattering is typically caused by scattering elements 9 inside the scattering layer 7. The density of the scattering layer 7 is then determined by the number of scattering elements 9 per unit volume of the scattering layer 7. The scattering layer 7 typically comprises a binder, such as silicone, which supports the scattering elements 9. The scattering elements 9 may for example be gas bubbles, titanium oxide particles, phosphor particles, metallic flakes, polymer beads or glass beads. The scattering elements 9 may be polymer inclusions having a different index of refraction than the binder

The scattering layer 7 has wavelength converting particles 10, which may or may not be the case in other embodiments. The wavelength converting particles 10 are dispersed throughout the scattering layer 7, the density of the wavelength converting particles 10, i.e. the number of wavelength converting particles 10 per unit volume of the scattering layer 7, being uniform or non-uniform. The wavelength converting particles 10 can be phosphor particles, for example organic phosphor particles or inorganic phosphor particles. Specific examples of phosphors include lutetium aluminum garnet and cerium doped yttrium aluminum garnet. The wavelength converting particles 10 may be particles of a luminescent material other than phosphor, for example Lumogen-Red. The wavelength converting particles 10 may be quantum dots. In some embodiments, the wavelength converting element 3 includes particles of the same type as the wavelength converting particles 10.

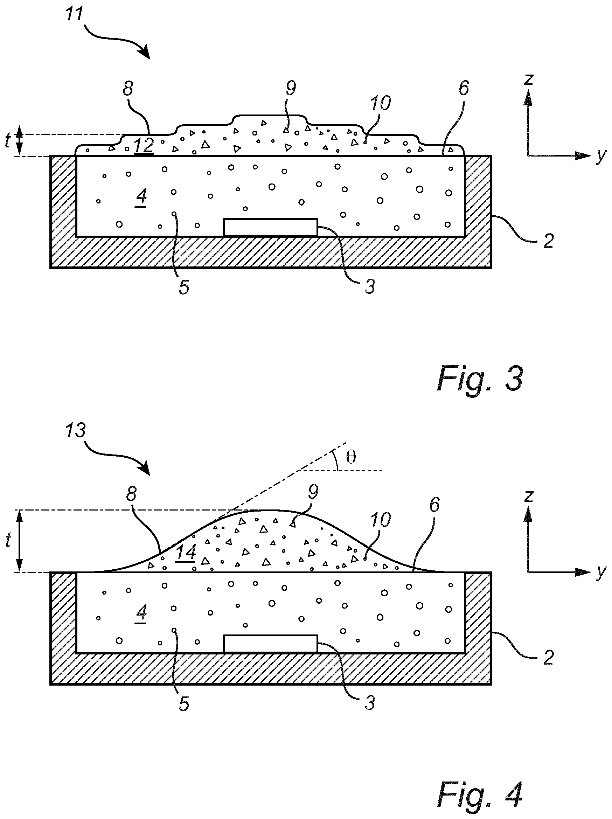

Figure 3 illustrates a light source assembly 11 which is similar to the light source assembly 1 in figure 1, except that the scattering layer 12 of this light source assembly 10 has a varying thickness t as measured perpendicular to the light emitting surface 6 (i.e. in the direction of the z-axis). The thickness t varies over the light emitting surface 7, that is to say, the thickness t varies in the x and y directions. The thickness t can for example vary between 50 µm to 200 µm, the thickest portion of the scattering layer 11 typically being above the SSL device 3 as viewed in the z direction. The thickness t varies in such a way as to scale with the variation in color of the light emitted from the light emitting surface 6. The back scattering strength is determined by the thickness t of the scattering layer 12, the backscattering strength being stronger where the scattering layer 12 is thicker. The scattering layer 12 may have a complex 3D shape and may have been applied to the light emitting surface by 6 means of an additive manufacturing method, such as 3D printing. Other techniques are conceivable. For example, the scattering layer 12 may be produced by overmoulding. Laser ablation may be a technique by which the scattering layer 12 is provided with a varying thickness t.

The density of the wavelength converting particles 10 in the scattering layer 12 is approximately uniform. The wavelength conversion strength of the scattering layer 12 is determined by the thickness t of the scattering layer 12, the wavelength conversion strength being stronger where the scattering layer 12 is thicker. This means that light passing through a thick portion of the scattering layer 12 is wavelength converted to a greater degree than light passing through a thin portion of the scattering layer 12. Again, it should be noted that the wavelength conversion particles 10 may be omitted in other embodiments.

Figure 4 illustrates a light source assembly 13 which is similar to the light source assembly 11 in figure 3. However, the light source assembly 13 in figure 4 has a scattering layer 14 in the form of a droplet. The scattering layer 14 thus has a bulge-like shape. Inkjet printing can be used to apply this type of scattering layer to the light emitting surface 6. The shape of the scattering layer 14 can be tuned by modifying the surface tension of the light emitting surface 6 and, hence, the contact angle θ. This can be done, for example, by applying a thin coating layer to the light emitting surface 6 or by subjecting the light emitting surface 6 to a treatment with plasma. The contact angle θ may for example be around 35°. The thickness t varies over the light emitting surface 7, the thickest portion of the scattering layer 14 typically being above the SSL device 3 as viewed in the z direction. The thickness of the thickest part may for example be between 50 µm and 200 µm.

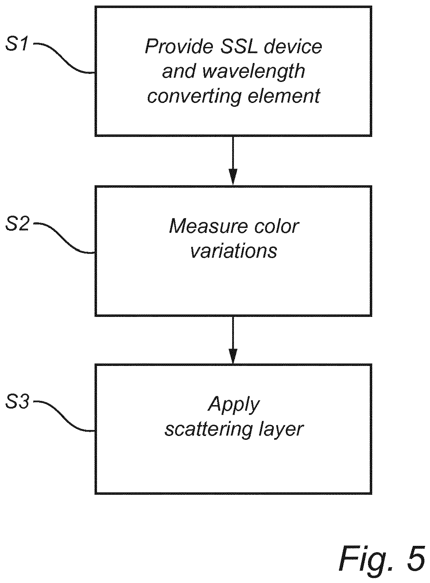

Figure 5 shows a flowchart of some of the steps of a method for manufacturing a light source assembly 8, 11,21 which will be discussed with reference to figures 1 to 4 as well as figure 5.

In step S1, an SSL device 3 and a wavelength converting element 4 are provided, the wavelength converting element 4 being arranged to receive light emitted by the SSL device 3 and adapted to convert some of the received light to a different wavelength. The SSL device 3 and wavelength converting element 3 may be part of an LED package, possibly an "off the shelf' LED package.

In step S2, variations in the color of the light emitted from a light emitting surface 6 of the wavelength converting element 4 are measured. Measuring the color variations may be done by using a near field receiver directly above the LED package or a source imaging goniometer. A digital camera equipped with at least three color filters that mimic the eye response curves X, Y and Z can be used to measure a colorimetric map of the emitting surface. The luminance L and the two color coordinates x_CIE and y_CIE are then determined for each pixel of the image, i.e. for each position of the emitting LED surface. Depending on the measured and the desired color coordinates a local correction is calculated and translated into a backscattering strength.

In step S3, a scattering layer 7, 12, 14 is applied to a light emitting surface 6 of the wavelength converting element 4. The scattering layer 7, 12, 14 is adapted to scatter light back to the wavelength converting element 4, and the backscattering strength of the scattering layer 7, 12, 14 is selected to vary over the light emitting surface 6 so as to reduce the measured variations in the color of the light emitted from the light emitting surface 6. The scattering layer 7, 12, 14 can be applied to the light emitting surface 6 by means of an additive manufacturing technique such as 3D printing. Inkjet printing can be used to apply the scattering layer 7, 12, 14 to the light emitting surface 6. The scattering layer 7, 12, 14 is then typically a droplet.

The step S3 may in some embodiments be succeeded by a step of providing the scattering layer with a varying thickness t by means of laser ablation. A scattering layer with substantially uniform thickness is then first applied to the light emitting surface 6 in step S3, after which thin portions of the scattering layer are removed by laser ablation.

When the light source assembly 1, 11, 13 is in use, the SSL device 3 emits light that is received by the wavelength converting element 4 which absorbs some of the received light and subsequently re-emits converted light having a different wavelength than the light emitted by the SSL device 3. A mix of the converted light and the light that has not been converted leaves the wavelength converting element 4 through the light emitting surface 6 and enters the scattering layer 7, 12, 14. A part of the light that has entered the scattering layer 7, 12, 14 passes directly through the scattering layer 7, 12, 14 and leaves through the light exit surface 8. Another part of the light is scattered back to the wavelength converting element 4 for another chance of being wavelength converted. The backscattering also spreads out the light throughout the LED package so that the intensity of the light is more uniform over the light emitting surface 6.

As an example, suppose that the SSL device 3 emits blue light, the converted light is yellow and the mixed light emitted from the light emitting surface 6 varies due to color over position so as to be bluish white when emitted from a center area directly above the SSL device 3 and increasingly yellowish white when emitted the closer to the edges of the light emitting surface 6. Differently stated, the color temperature of the emitted light deceases as the position of emission moves from the center to the edges. In a situation such as this, the scattering layer 7, 12, 14 is adapted to scatter a relatively high proportion of the light from the center area back to the wavelength converting element 4. This increases the conversion degree and increases the yellow color component of the light from the center area, and the color differences in the light emitted from the light emitting surface 6 are reduced as a result of a smoothing out of the transition between the center area emitting bluish white light and the area closer to the edges emitting yellowish white light. The light leaving the light exit surface 8 thus has a more uniform color and a lower color temperature average than light leaving the light emitting surface 6 would have had if there had been no scattering layer 7, 12, 14, the effect being noticeable to an observer in the near field as well as in the far field.

The person skilled in the art realizes that the present invention by no means is limited to the preferred embodiments described above. On the contrary, many modifications and variations are possible within the scope of the appended claims. For example, the light emitting surface 6 may for example have the shape of a dome or some other non flat shape. Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A light source assembly (1, 11, 13) comprising:
a solid state lighting device (3);
a wavelength converting element (4) arranged to receive light emitted by the solid state lighting device (3), adapted to convert some of the received light to a different wavelength and comprising a light emitting surface (6) ; and
a scattering layer (7, 12, 14) applied to the light emitting surface (6) of the wavelength converting element (4) and adapted to scatter light received from the wavelength converting element (4),
**characterized in that**,
the scattering layer (7, 12, 14) is adapted to scatter light back through the light emitting surface (6) into the wavelength converting element (4),
the scattering layer (7, 12, 14) has a backscattering strength that varies over said light emitting surface (6) so as to reduce variations in the color of the light emitted from the light emitting surface (6), and
the backscattering strength of the scattering layer (7, 12, 14) varies in the range of 10% to 50% of the light emitted from the light emitting surface (6).

2. The light source assembly (1, 11, 13) according to claim 1, wherein the scattering layer (7, 12, 14) has a varying density, the backscattering strength being determined by said density.

3. The light source assembly (1, 11, 13) according to claim 1 or 2, wherein the scattering layer (7, 12, 14) has a varying thickness perpendicular to the light emitting surface (6), the backscattering strength being determined by said thickness.

4. The light source assembly (1, 11, 13) according to any of the preceding claims, wherein the scattering layer (7, 12, 14) comprises scattering elements (9) chosen from the group consisting of gas bubbles, titanium oxide particles and phosphor particles.

5. The light source assembly (1, 11, 13) according to any of the preceding claims, wherein the scattering layer (7, 12, 14) comprises wavelength converting particles (10).

6. The light source assembly (1, 11, 13) according to claim 5, wherein the wavelength converting element (4) and the scattering layer (7, 12, 14) comprise the same type of wavelength converting particles (5, 10).

7. The light source assembly (1, 11, 13) according to claim 5 or 6, wherein the wavelength converting particles (5, 10) are phosphor particles.

8. The light source assembly (1, 11, 13) according to any of the preceding claims, wherein the color of the light leaving the light emitting surface (6) depends on the position from which the light leaves the light emitting surface (6).

9. The light source assembly (1, 11, 13) according to any of the preceding claims, wherein the light emitting surface (6) is flat.

10. A method for manufacturing a light source assembly (1, 11, 13), comprising:
providing a solid state lighting device (3) and a wavelength converting element (4), wherein the wavelength converting element (4) is arranged to receive light emitted by the solid state lighting device (3) and adapted to convert some of the received light to a different wavelength;
measuring variations in the color of the light emitted from a light emitting surface (6) of the wavelength converting element (4); and
applying a scattering layer (7, 12, 14) to the light emitting surface (6);
wherein the scattering layer (7, 12, 14) is adapted to scatter light through the light emitting surface (6) back into the wavelength converting element (4), and wherein a backscattering strength of the scattering layer (7, 12, 14) is selected to vary over said light emitting surface (6) so as to reduce the measured variations in the color of the light emitted from the light emitting surface (6), and
wherein the back scattering strength varies in the range of 10% to 50% of the light emitted from the light emitting surface.

11. The method according to claim 10, wherein the scattering layer (7, 12, 14) is applied by additive manufacturing techniques.

12. The method according to claim 10, wherein the scattering layer (7, 12, 14) is applied to the light emitting surface (6) in the form of a droplet.

## Patentansprüche

1. Lichtquellenanordnung (1, 11, 13), umfassend:
eine Festkörper-Beleuchtungsvorrichtung (3),
ein Wellenlängen-Umwandlungselement (4), das angeordnet ist, um Licht aufzunehmen, das von der Festkörper-Beleuchtungsvorrichtung (3) emittiert wird, ausgelegt, um einen Teil des aufgenommenen Lichts in eine verschiedene Wellenlänge umzuwandeln, und umfassend eine lichtemittierende Fläche (6); und
eine Streuschicht (7, 12, 14), die auf die lichtemittierende Fläche (6) des Wellenlängen-Umwandlungselements (4) angewendet und ausgelegt ist, um Licht, aufgenommen vom Wellenlängen-Umwandlungselement (4), zu streuen,
**dadurch gekennzeichnet, dass**
die Streuschicht (7, 12, 14) ausgelegt ist, um Licht zurück durch die lichtemittierende Fläche (6) in das Wellenlängen-Umwandlungselement (4) zu streuen,
die Streuschicht (7, 12, 14) eine Rückstreustärke aufweist, die über die lichtemittierende Fläche (6) variiert, um die Variationen der Farbe des Lichts zu reduzieren, das von der lichtemittierenden Fläche (6) emittiert wird, und
die Rückstreustärke der Streuschicht (7, 12, 14) im Bereich von 10 % bis 50 % des Lichts variiert, das von der lichtemittierenden Fläche (6) emittiert wird.

2. Lichtquellenanordnung (1, 11, 13) nach Anspruch 1, wobei eine Streuschicht (7, 12, 14) eine variable Dichte aufweist, wobei die Rückstreustärke durch die Dichte bestimmt wird.

3. Lichtquellenanordnung (1, 11, 13) nach Anspruch 1 oder 2, wobei die Streuschicht (7, 12, 14) eine variable Dicke senkrecht zur lichtemittierenden Fläche (6) aufweist, wobei die Rückstreustärke durch die Dicke bestimmt wird.

4. Lichtquellenanordnung (1, 11, 13) nach einem der vorhergehenden Ansprüche, wobei die Streuschicht (7, 12, 14) Streuelemente (9) umfasst, ausgewählt aus der Gruppe, bestehend aus Gasblasen, Titanoxidpartikel und Phosphorpartikel.

5. Lichtquellenanordnung (1, 11, 13) nach einem der vorhergehenden Ansprüche, wobei die Streuschicht (7, 12, 14) Wellenlängen-Umwandlungspartikel (10) umfasst.

6. Lichtquellenanordnung (1, 11, 13) nach Anspruch 5, wobei das Wellenlängen-Umwandlungselement (4) und die Streuschicht (7, 12, 14) die gleiche Art von Wellenlängen-Umwandlungspartikeln (5, 10) umfasst.

7. Lichtquellenanordnung (1, 11, 13) nach Anspruch 5 oder 6, wobei die Wellenlängen-Umwandlungspartikel (5, 10) Phosphorpartikel sind.

8. Lichtquellenanordnung (1, 11, 13) nach einem der vorhergehenden Ansprüche, wobei die Farbe des Lichts, das die lichtemittierende Fläche (6) verlässt, von der Position abhängt, von der das Licht die lichtemittierende Fläche (6) verlässt.

9. Lichtquellenanordnung (1, 11, 13) nach einem der vorhergehenden Ansprüche, wobei die lichtemittierende Fläche (6) flach ist.

10. Verfahren zur Herstellung einer Lichtquellenanordnung (1, 11, 13), umfassend:
Bereitstellen einer Festkörper-Beleuchtungsvorrichtung (3) und eines Wellenlängen-Umwandlungselements (4), wobei das Wellenlängen-Umwandlungselement (4) angeordnet ist, um Licht aufzunehmen, das von der Festkörper-Beleuchtungsvorrichtung (3) emittiert wird, und ausgelegt, um einen Teil des aufgenommenen Lichts in eine verschiedene Wellenlänge umzuwandeln;
Messen von Variationen der Farbe des Lichts, das von einer lichtemittierenden Fläche (6) des Wellenlängen-Umwandlungselements (4) emittiert wird; und
Anwenden einer Streuschicht (7, 12, 14) die auf die lichtemittierende Fläche (6);
wobei die Streuschicht (7, 12, 14) ausgelegt ist, um Licht durch die lichtemittierende Fläche (6) zurück in das Wellenlängen-Umwandlungselement (4) zu streuen, und wobei eine Rückstreustärke der Streuschicht (7, 12, 14) ausgewählt ist, die über die lichtemittierende Fläche (6) zu variieren, um die gemessenen Variationen der Farbe des Lichts zu reduzieren, das von der lichtemittierenden Fläche (6) emittiert wird, und
wobei die Rückstreustärke im Bereich von 10 % bis 50 % des Lichts variiert, das von der lichtemittierenden Fläche emittiert wird.

11. Verfahren nach Anspruch 10, wobei die Streuschicht (7, 12, 14) durch additive Herstellungstechniken angewendet wird.

12. Verfahren nach Anspruch 10, wobei die Streuschicht (7, 12, 14) auf die lichtemittierende Fläche (6) in Form von Tröpfchen aufgebracht wird.

## Revendications

1. Ensemble de source de lumière (1, 11, 13) comprenant :
un dispositif d'éclairage à semi-conducteurs (3) ;
un élément de conversion de longueur d'onde (4) agencé pour recevoir la lumière émise par le dispositif d'éclairage à semi-conducteurs (3), conçu pour convertir une partie de la lumière reçue en une longueur d'onde différente et comprenant une surface d'émission de lumière (6) ; et
une couche de diffusion (7, 12, 14) appliquée à la surface d'émission de lumière (6) de l'élément de conversion de longueur d'onde (4) et conçue pour diffuser la lumière reçue de l'élément de conversion de longueur d'onde (4),
**caractérisé en ce que**
la couche de diffusion (7, 12, 14) est conçue pour rétrodiffuser la lumière à travers la surface d'émission de lumière (6) dans l'élément de conversion de longueur d'onde (4),
la couche de diffusion (7, 12, 14) a une intensité de rétrodiffusion qui varie sur ladite surface d'émission de lumière (6) de manière à réduire les variations de la couleur de la lumière émise à partir de la surface d'émission de lumière (6), et
l'intensité de rétrodiffusion de la couche de diffusion (7, 12, 14) varie dans la plage de 10 % à 50 % de la lumière émise à partir de la surface d'émission de lumière (6).

2. Ensemble de source de lumière (1, 11, 13) selon la revendication 1, dans lequel la couche de diffusion (7, 12, 14) a une densité variable, l'intensité de rétrodiffusion étant déterminée par ladite densité.

3. Ensemble de source de lumière (1, 11, 13) selon la revendication 1 ou 2, dans lequel la couche de diffusion (7, 12, 14) a une épaisseur variable perpendiculaire à la surface d'émission de lumière (6), l'intensité de rétrodiffusion étant déterminée par ladite épaisseur.

4. Ensemble de source de lumière (1, 11, 13) selon l'une quelconque des revendications précédentes, dans lequel la couche de diffusion (7, 12, 14) comprend des éléments de diffusion (9) choisis dans le groupe consistant en des bulles de gaz, des particules d'oxyde de titane et des particules de phosphore.

5. Ensemble de source de lumière (1, 11, 13) selon l'une quelconque des revendications précédentes, dans lequel la couche de diffusion (7, 12, 14) comprend des particules de conversion de longueur d'onde (10).

6. Ensemble de source de lumière (1, 11, 13) selon la revendication 5, dans lequel l'élément de conversion de longueur d'onde (4) et la couche de diffusion (7, 12, 14) comprennent le même type de particules de conversion de longueur d'onde (5, 10).

7. Ensemble de source de lumière (1, 11, 13) selon la revendication 5 ou 6, dans lequel les particules de conversion de longueur d'onde (5, 10) sont des particules de phosphore.

8. Ensemble de source de lumière (1, 11, 13) selon l'une quelconque des revendications précédentes, dans lequel la couleur de la lumière sortant de la surface d'émission de lumière (6) dépend de la position à partir de laquelle la lumière sort de la surface d'émission de lumière (6).

9. Ensemble de source de lumière (1, 11, 13) selon l'une quelconque des revendications précédentes, dans lequel la surface d'émission de lumière (6) est plate.

10. Procédé pour fabriquer un ensemble de source de lumière (1, 11, 13), comprenant:
la fourniture d'un dispositif d'éclairage à semi-conducteurs (3) et d'un élément de conversion de longueur d'onde (4), dans lequel l'élément de conversion de longueur d'onde (4) est agencé pour recevoir la lumière émise par le dispositif d'éclairage à semi-conducteurs (3) et conçu pour convertir une partie de la lumière reçue en une longueur d'onde différente;
la mesure des variations de la couleur de la lumière émise à partir d'une surface d'émission de lumière (6) de l'élément de conversion de longueur d'onde (4); et
l'application d'une couche de diffusion (7, 12, 14) à la surface d'émission de lumière (6);
dans lequel la couche de diffusion (7, 12, 14) est conçue pour rétrodiffuser la lumière à travers la surface d'émission de lumière (6) dans l'élément de conversion de longueur d'onde (4), et dans lequel une intensité de rétrodiffusion de la couche de diffusion (7, 12, 14) est sélectionnée pour varier sur ladite surface d'émission de lumière (6) de manière à réduire les variations mesurées de la couleur de la lumière émise à partir de la surface d'émission de lumière (6), et
dans lequel l'intensité de rétrodiffusion varie dans la plage de 10 % à 50 % de la lumière émise à partir de la surface d'émission de lumière.

11. Procédé selon la revendication 10, dans lequel la couche de diffusion (7, 12, 14) est appliquée par des techniques de fabrication additive.

12. Procédé selon la revendication 10, dans lequel la couche de diffusion (7, 12, 14) est appliquée à la surface d'émission de lumière (6) sous la forme d'une gouttelette.
